# EUROPEAN PATENT APPLICATION

(11) **EP 1 847 879 A2**
(43) Date of publication of application: **24.10.2007**
(21) Application number: 07007693.0
(22) Date of filing: 16.04.2007
(51) Int. Cl.: G03F 7/36, B41F 35/00

(54) **Method for cleaning an automatic process device**

(30) Priority: 21.04.2006 US 409403
(71) Applicant: E.I. du Pont de Nemours and Company, Wilmington, DE 19898 (US)
(72) Inventor: Chang, Hao, Lansdale, Pennsylvania 19446 (US); Armstrong, Mark L., Wilmington, Delaware 19803 (US)
(74) Representative: Hughes, Andrea Michelle

(57) **Abstract**

This invention pertains to a method for cleaning an automatic process device. The device is an apparatus for thermally treating a photosensitive element to form a relief surface. One or more contactable surfaces in the device can become contaminated with residue or other materials deposited from the photosensitive element during thermal treating and/or foreign bodies from ambient environment. A cleaning element having an adhesive layer on a support removes or reduces the level of contaminants on the contactable surface. The method includes passing the cleaning element through the device so that the adhesive layer contacts the contactable surfaces and thereby transfers at least one of the contaminants to the adhesive layer.

## Description

### BACKGROUND OF THE INVENTION

### FIELD OF THE DISCLOSURE

This invention pertains to a method for cleaning contaminants in an automatic process device, and particularly to a method for cleaning a device for thermally treating a photosensitive element.

### DESCRIPTION OF RELATED ART

Flexographic printing plates are well known for use in printing surfaces which range from soft and easy to deform to relatively hard, such as packaging materials, e.g., cardboard, plastic films, aluminum foils, etc. Flexographic printing plates can be prepared from photosensitive elements containing photopolymerizable compositions, such as those described in U.S. Patents 4,323,637 and 4,427,759. The photopolymerizable compositions generally comprise an elastomeric binder, at least one monomer and a photoinitiator. Photosensitive elements generally have a photopolymerizable layer interposed between a support and a coversheet or multilayer cover element. Upon imagewise exposure to actinic radiation, photopolymerization of the photopolymerizable layer occurs in the exposed areas, thereby curing and rendering insoluble the exposed areas of the layer. Conventionally, the element is treated with a suitable solution, e.g., solvent or aqueous-based washout, to remove the unexposed areas of the photopolymerizable layer leaving a printing relief which can be used for flexographic printing. However, developing systems that treat the element with a solution are time consuming since drying for an extended period (0.5 to 24 hours) is necessary to remove absorbed developer solution.

As an alternative to solution development, a "dry" thermal development process may be used which removes the unexposed areas without the subsequent time-consuming drying step. In a thermal development process, the photosensitive layer, which has been imagewise exposed to actinic radiation, is contacted with an absorbent material at a temperature sufficient to cause the composition in the unexposed portions of the photosensitive layer to soften or melt and flow into an absorbent material. See U.S. Patents 3,060,023 (Burg et al.); 3,264,103 (Cohen et al.); 5,015,556 (Martens); 5,175,072 (Martens); 5,215,859 (Martens); and 5,279,697 (Peterson et al.). The exposed portions of the photosensitive layer remain hard, that is do not soften or melt, at the softening temperature for the unexposed portions. The absorbent material collects the softened un-irradiated material and then is separated from the photosensitive layer. The cycle of heating and contacting the photosensitive layer may need to be repeated several times in order to sufficiently remove the flowable composition from the un-irradiated areas and form a relief structure suitable for printing. After such processing, there remains a raised relief structure of irradiated, hardened composition that represents the irradiated image.

Processors for thermal development of flexographic printing elements are known. U.S. 5,279,697 and U.S. 6,797,454 each describe an automated process and apparatus for handling an irradiated printing element and accomplishing repeated heating and pressing to remove the unirradiated composition from the element with a web of absorbent material. Both apparatuses include a drum for supporting the photosensitive element during thermal development. An outer surface of the drum may be tacky to temporarily adhere the photosensitive element to the drum. The drum may also include a clamp for securing a leading edge of the photosensitive element to the outer surface of the drum. The apparatuses may also include one or more rollers, which may be referred to as steady rollers or laydown rollers or contacting rollers, adjacent to the outer surface of the drum that aid in holding the photosensitive element to the drum surface during rotation of the drum. The photosensitive element is mounted on the drum with the element residing on the tacky layer and, during thermal development the one or more steady rollers contact an outermost surface of the photosensitive element.

A problem sometimes arises during thermal development that one or more material components, such as waxes, binders, plasticizers, oils, monomers, oligomers, and/or other additives in the layer or layers of the photosensitive element transfer to an outer surface of the contacting roller and deposit a residue on the roller. Sometimes residue deposits on the contacting roller even if the contacting roller has a nonstick surface. The residue on the outer surface of the contacting roller can accumulate and can ultimately contaminate or damage the relatively soft printing surface of subsequently processed photosensitive elements. Excessive accumulation of material components on the contacting roller can cause the residue to form flake contaminants that attach to the surface of the photosensitive element. Excessive accumulation of material components on the outer surface of the contacting roller can also harden, and the hardened residue can then indent the printing surface of the photosensitive element. In addition, the contaminants on the contacting roller/s may transfer to other surfaces in the processor and make it difficult to maintain the cleanliness of the processor. A printing form having a damaged or contaminated printing surface can result in unacceptable print quality. The formation of contaminants originating from the thermal processing of photosensitive elements in the processor typically depends on usage, with plate type, high volume and large plate size being contributing factors.

In addition, the outer surface of the contacting roller may accumulate foreign bodies such as fibers, hairs, fur, dust, etc. from ambient environment in and around the processor. During thermal development the foreign bodies can also transfer to the exterior surface of the photosensitive element and contaminate the printing form. Contaminants remaining on the printing form for printing can result in unacceptable print quality. Sometimes the contaminants originating from ambient environment, as well as those contaminants from the material components of the photosensitive element, can be removed from the printing form by wiping the relief surface after development. But this is an undesired step that can consume platemaking time and manpower, and does not always successful provide clean, uncontaminated printing forms.

### SUMMARY OF THE INVENTION

It is desirable to provide a method for cleaning at least one surface in an automatic process device that contacts a photosensitive element. It is also desirable to provide a method for removing or reducing the buildup of residue on surfaces contacting the photosensitive element.

In accordance with this invention there is provided a method for cleaning contaminants from an automatic process device for forming a relief surface from a photosensitive element having an exterior surface and containing a composition layer capable of being partially liquefied. The method includes providing the device with a contactable surface capable of contacting the exterior surface of the element where a portion of the composition can remain. The contactable surface has at least one contaminant thereon. The method includes providing a cleaning element comprising a support having on one side an adhesive layer adapted to contact the contactable surface. The method includes passing the cleaning element through the device so that the adhesive layer contacts the contactable surface and thereby transfers the at least one contaminant from the contactable surface onto the adhesive layer.

### DESCRIPTION OF THE PREFERRED EMBODIMENTS

The present invention is a method for cleaning contaminants from an automatic process device. In particular, the automatic process device is an apparatus for thermally developing a photosensitive element. The apparatus includes one or more contactable surfaces that are capable of contacting the element such that a portion of the element can remain as at least one contaminant on the at least one contactable surface. The method includes passing a cleaning element having an adhesive layer through the device so that the adhesive layer contacts at least one of the contactable surfaces and transfers the contaminant or contaminants to the adhesive layer to capture and ultimately remove the contaminant/s from the device. The method of cleaning contaminants from the contactable surfaces of the automatic process device is easy to do, inexpensive, and efficient as it avoids manual cleaning of the contactable surfaces in the device.

Apparatuses suitable for thermally developing or treating the photosensitive element are disclosed by Peterson et al. in US Patent 5,279,697, and by Johnson et al. in US Patent 6,797,454. Although these patent publications depict that the photosensitive element is preferably placed on a drum for thermal treatment, it should be understood that the element could be placed on a planar surface or on a combination of planar surface/s and roll/s, such as a belt supported system, for treatment. It should also be understood that one of ordinary skill in the art could modify the disclosed apparatus to accommodate mounting of the photosensitive element in the form of a cylinder or a sleeve on the drum or a suitable support structure. Another apparatus suitable for thermally developing is described in U.S. patent application serial number 11/269096 filed November 8, 2005 (attorney docket number GP-1212) which develops a cylindrically-shaped photosensitive element. Other thermal processing devices suitable for treating photosensitive elements are disclosed in US Patent 6,998,218 B2; US Publication No. 2005/0211120 A1; US Publication No. 2005/0211121 A1; and US Publication No. 2005/0241509 A1. Each of these automatic process devices includes or can be modified by one of ordinary skill in the art to include at least one contactable surface that is capable of contacting an exterior surface of the photosensitive element. Thermal development apparatuses that include one or more members, such as a roll, roller, and/or guide plates, having a surface capable of contacting an exterior surface of the photosensitive element, that is a contactable surface, are particularly suited for the present cleaning method. Rollers having a contactable surface may also be referred to as steady rollers or laydown rollers or contacting rollers. Typically, the contacting rollers or guides are adjacent to a support member, such as a drum, that supports the photosensitive element during thermal development. An outside surface of the rollers or guides contacts the exterior surface of the photosensitive element to keep the photosensitive element on the support member or prevent the element from lifting off during thermal development, particularly in the case in which the element rotates on the support member having a drum shape.

Thermal development heats the photosensitive element to a development temperature that causes uncured portions of the composition layer to liquefy, i.e., melt or soften or flow, and be removed or carried away by contact with a development medium. The development medium may also be referred to herein as development material, development web, absorbent material, absorbent medium, and web. Cured portions of the photosensitive layer have a higher melting or softening or liquefying temperature than the uncured portions and therefore do not melt, soften, or flow at the thermal development temperatures. The remaining cured portions of the element form a relief surface suitable for use as a flexographic printing form. Thermal development of photosensitive elements to form flexographic printing plates is described in U.S. 5,015,556; U.S. 5,175,072; U.S. 5,215,859; and WO 98/13730. The photosensitive element includes a substrate and at least a composition layer, and in particular a photopolymerizable composition layer, on the substrate. The composition layer is capable of being partially liquefied.

The thermal treating steps of heating the photosensitive element and contacting an outermost surface of the element with an absorbent material can be done at the same time, or in sequence provided that the uncured portions of the photopolymerizable layer are still soft or in a melt state when contacted with the absorbent material. A cycle of the steps of heating the photopolymerizable layer and contacting the molten (portions) layer with the development medium can be repeated as many times as necessary to adequately remove the uncured material and create a relief surface of sufficient relief depth.

The term "melt" is used to describe the behavior of the unirradiated portions of the composition layer subjected to an elevated temperature that softens and reduces the viscosity to permit absorption by the absorbent material. The material of the meltable portion of the composition layer is usually a viscoelastic material which does not have a sharp transition between a solid and a liquid, so the process functions to absorb the heated composition layer at any temperature above some threshold for absorption in the development medium. Thus, the unirradiated portions of the composition layer soften or liquefy when subjected to an elevated temperature. However throughout this specification the terms "melting", "softening", and "liquefying" may be used to describe the behavior of the heated unirradiated portions of the composition layer, regardless of whether the composition may or may not have a sharp transition temperature between a solid and a liquid state. A wide temperature range may be utilized to "melt" the composition layer for the purposes of this invention. Absorption may be slower at lower temperatures and faster at higher temperatures during successful operation of the process.

Contactable surfaces in an automatic process device can tend to accumulate material from one or more layers of the photosensitive element as the element is treated, and thereby become contaminated. During thermal treatment, as the at least one contactable surface touches the exterior surface of the photosensitive element, portions of the element can remain on the contactable surface. In particular, the at least one contactable surfaces typically contact the element in between one cycle of heating the element and contacting with the absorbent material and a subsequent cycle of heating and contacting. During this interval, the photosensitive element may have cooled from the development temperature and the exterior surface of the element may include residue from one or more components in the composition layer or other layers or may include composition from the photopolymerizable layer that was not completely removed during contacting. The residue of components or portions of the composition layer can transfer to the contactable surface as the contactable member touches the exterior of the photosensitive element. In general, the photopolymerizable composition material or components from the photopolymerizable composition, such as for example, waxes, oils, binders, plasticizers, oligomers, are the components that contaminate the contactable surfaces since the photopolymerizable layer is typically the bulk portion of the photosensitive element. Foreign bodies, such as fibers, hair, fur, and dust, from the ambient environment in and around the automatic process device can also contaminate the contactable surfaces.

A cleaning element is provided to decontaminate the residue of components or portions of the composition layer and/ or the foreign bodies from the at least one contactable surfaces. Cleaning of the automatic process device can constitute complete removal or partial removal of one or more contaminants from one or more of the at least one contactable surfaces in the device. In one embodiment, the cleaning element removes the at least one contaminate from the contactable surface. In another embodiment, the cleaning element reduces the level of the at least one contaminate from the contactable surface. In another embodiment, the cleaning element minimizes the build up of the at least one contaminate transferring to the contactable surface. The cleaning element having an adhesive layer is passed through the device so that the adhesive layer contacts at least one of the contactable surfaces, or a portion thereof, and the at least one contaminant transfers to the cleaning element. The cleaning element captures the at least one contaminant for removal from the process.

The cleaning element includes at least a support having on one side an adhesive layer adapted to contact the at least one contactable surface. The support is not limited and can be selected from polymeric films, metal, paper, and combinations thereof. The support can be almost any polymeric material that forms films that are non-reactive and remain stable throughout conditions for cleaning the device. Examples of suitable film supports include cellulosic films and thermoplastic materials such as polyolefins, polycarbonates, and polyester. Preferred are films of polyethylene. Examples of metals suitable as the support include aluminum, nickel, and steel.

While not critical to successful cleaning with the cleaning element, the support should be sufficiently stable throughout the conditions for cleaning the device, so as to have no or minimal distortion and change in dimensional size. In one embodiment the support of the cleaning element is sufficiently flexible to bring the adhesive layer into contact with the contactable surface while passing through the device. Typically the support has a thickness between 0.4 to 5 mils (0.001 to 0.013cm), but is not particularly limited to this range. The support can be in any form including cylindrical, and sheet. In one embodiment, the support has a thickness less than 1 mil (0.0025 cm).

A surface of the support can include an adhesion-promoting surface, such as a primer layer, or can be treated to promote adhesion of the adhesive layer to the support. The surface of the support can include a subbing layer of an adhesive material or primer or an anchor layer to give strong adherence between the support and the adhesion layer. The subbing compositions that are disclosed in U.S. Patent 2,760,863 and U.S. Patent 3,036,913 are suitable. The surface of the support can be treated to promote adhesion between the support and the adhesive layer, with flame-treatment or electron-treatment, e.g., corona-treated.

The cleaning element includes the adhesive layer on at least one side of the support. The adhesive layer can be on the adhesion-promoting surface or on the primer layer of the support, or directly the surface of the support. The adhesive layer covers all or substantially all the surface of the support. The adhesive is not limited provided that the adhesive captures the at least one contaminants from the contactable surface; is transfer-resistant, that is, does not transfer from the support to the contactable surface; and is stable, for example does not melt or degrade, at the temperature at which the cleaning process occurs. In one embodiment, the adhesive is a pressure-sensitive adhesive. In an alternate embodiment, the adhesive is a thermally activated adhesive. Adhesives suitable for use can be found in "Handbook of Adhesives", edited by I. Skeist, Third Edition, Van Nostrand Reinhold Company, New York, 1990, particularly Chapter 38. Examples of suitable adhesives include, but are not limited to, natural rubber; butyl rubber; styrenic block copolymers, such as styrene-isoprene-styrene block copolymers and styrene-butadiene block copolymers; styrene-butadiene rubbers; homopolymers of isobutylene; ethylene-vinyl acetate copolymers; acrylics, such as poly(acrylate esters), and acrylic latexes; silicones; and combinations thereof. The adhesive composition may also include additives to adjust the adhesive or other properties of the layer or to aid in the application of the adhesive to form a layer on the substrate. The thickness of the adhesive layer is not limited. In one embodiment, the thickness of the adhesive layer can be between 0.5 to 13 micrometers (microns). In another embodiment, the thickness of the adhesive layer can be between 0.1 to 15.0 mils (0.0025 to 0.38 millimeters).

The adhesive layer has a tackiness sufficient to capture the at least one contaminant from the contactable surface. The tackiness of the adhesive layer will typically change, that is decrease in tackiness, as contaminants are captured by the cleaning element. There is no particular maximum tackiness to the adhesive layer provided that a highly tacky adhesive does not alter functionality of the cleaning element or harm the device during the cleaning or subsequently processed photosensitive elements.

The tackiness of the adhesive layer can be determined by ASTM method D2979. For tack testing according to ASTM D2979 an inverted probe tack apparatus was duplicated using a Model 1122 Instron CRE test frame, modified by Instru-Met Corporation to run using MTS Sintech Testworks 4 software. A 500g Sensotech load cell was mounted on a stand attached to the base of the frame. The probe was attached to the top of the load cell and extended up through the crosshead, such that the annular weight and sample contacted the probe above the crosshead. A down, one second hold, then up cycle, thus loaded the specimen as required. Peak load was recorded for each test. Typically, a set of 5 separate specimens was tested for each sample of the adhesive on the cleaning element.

Typically the tackiness of the adhesive layer is at least 0.1 Newton. In one embodiment the tackiness of the adhesive layer is between 0.1 and 0.7 Newton. In another embodiment the tackiness of the adhesive layer is between 0.3 and 0.5 Newton.

The cleaning element can be an individual sheet or form composed of the substrate having an adhesive layer thereon. In an alternate embodiment, the cleaning element can be two or more individual sheets of cleaning elements stacked one on top of the other forming a stack of cleaning elements. The individual cleaning elements remain together as a stack to function substantially as an individual cleaning element but yet are capable of being individually separated from the stack. In one embodiment, two or more cleaning elements can be stacked one upon another. In another embodiment, 20 to 40 cleaning elements are placed one upon another to form the stack of cleaning elements. Optionally, the stack of cleaning elements may include a carrier on the backside of the lowermost cleaning element of the stack to support the stack and/or protect the lowermost cleaning element. Materials suitable as the carrier include the materials described above for the support of the cleaning element. The carrier has a thickness that can be the same as or thicker than the thickness of the support for the cleaning element, that is, the carrier can have a thickness between 0.4 to 10 mils (0.001 to 0.025cm).

It may be necessary to treat the backside of the support of each of the cleaning elements in a stack in order to enable removal of an individual cleaning element from the stack. The backside of the support is a side of the support opposite the side having the adhesive layer. The backside of cleaning elements intending to form a stack can be treated as described above to include an adhesion-promoting surface, such as a primer, or surface treatment to promote sufficient adherence (but temporary) of the backside of the support of the uppermost cleaning element to the adhesive layer of the underlying cleaning element while stacked together. The backside surface treatment can be the same or different from the treatment provided to the side of the support with the adhesion layer. The support of a cleaning element that is part of a stack of cleaning elements should also have sufficient strength to withstand an adhesive pull load without tearing, stretching, or distorting. The tensile strength of the support, that is, the maximum stress the support subjected to a stretching load can withstand without tearing, can be determined by standard test method ASTM D882. In one embodiment, polyethylene films having a tensile strength of at least 2500 psi are suitable for use as the support. The modulus of elasticity and the yield point of the support, which reflects the stretching and distortion strength of the support, can be determined by standard test method ASTM D5035.

In order to accommodate thickness of the photosensitive elements during thermal development, there may be a gap between the at least one contactable surface and the surface of the support member (absent the photosensitive element). In one embodiment, the total thickness of the cleaning element is determined by the gap, so that the adhesive layer of the cleaning element can readily contact the at least one contactable surface of the processing device. In an alternate embodiment, the gap between the at least one contactable surface and the surface of the support member is adjustable in order to accommodate photosensitive elements of various thicknesses and cleaning elements of various thicknesses to assure appropriate contact with the contactable surface. In one embodiment, gravity may position a member having the contactable surface into pressure contact with the exterior surface of the photosensitive element and the adhesive layer of the cleaning element. In another embodiment, the member having the contactable surface may be spring-loaded for pressure contact of the contactable surface to the exterior surfaces of the photosensitive element and the cleaning element.

Any embodiment of the cleaning element has a thickness that is sufficient to provide contact of the adhesive layer to at least one of the contactable surfaces of the device. In one embodiment a stack of cleaning elements can have a (combined) thickness between 20 to 250 mil (0.051 to 0.64 cm). In another embodiment, an individual cleaning element can have a thickness between 20 to 250 mil (0.051 to 0.64 cm). In yet another embodiment, the cleaning element can have a thickness between 0.4 to 20 mil (0.001 to 0.050 cm). In yet another embodiment, the cleaning element can be positioned on a carrier having the thickness necessary for the adhesive layer to contact the at least one contactable surface as the cleaning element passes through the device.

The cleaning element can have one or more dimensions determined according to one or more dimensions of the at least one contactable surface. In an embodiment where the cleaning element is in sheet form, the cleaning element can have an area (planar) dimension, that is width by length, that is is capable of contacting the entire contactable surface, of for example a laydown roller, in one pass. In an alternate embodiment, the cleaning element can have dimensions smaller that the contactable surface such that multiple passes of the cleaning element are required at the same and/or different adjacent locations in order to assure thorough contact of the entire contactable surface by the cleaning element.

Embodiments of cleaning elements suitable for use in the present process are commercially available and can be purchased as Cleanline Mats from Controlled Environment Equipment Corp. (Gorham, ME); Trim Tack Floor Mats from Markel Industries, Inc. (Manchester, CT); Tacky Mat from Liberty Industries, Inc. (East Berlin, CT); Purus Mat from Purestp International; and Tack Mat from ITW Alma (Kennesaw, GA).

In the thermal development device, the photosensitive element is heated to liquefy the composition layer and a development medium is contacted to the exterior surface of the element to remove the liquefied composition and form a relief surface. Thermal developing, which may also be called thermal treating, includes heating of the exterior surface of the composition layer of the photosensitive element to a temperature sufficient to cause a portion of the layer to liquefy. The at least one photosensitive layer (and additional layer/s if present) can be heated by conduction, convection, radiation or other heating methods to a temperature sufficient to effect melting of the uncured portions but not so high as to effect distortion of the cured portions of the layer. One or more additional layers disposed above the composition layer may soften or melt or flow and be absorbed as well by an absorbent material. The photosensitive element is heated to a surface temperature above about 40°C, preferably from about 40°C to about 230°C (104-446 °F) in order to effect melting or flowing of the uncured portions of the composition layer. The thermal treating steps of heating the photosensitive element and contacting an outermost surface of the element with the development medium can be done at the same time, or in sequence provided that the uncured portions of the photopolymerizable layer are still soft or in a melt state when contacted with the absorbent material.

In one embodiment for thermal development in an automatic process device, the support member for the photosensitive element is a drum and adjacent to an outer surface of the drum is at least one steady roller that aids in holding the photosensitive element to the drum surface during rotation of the drum. The at least one steady roller has a contactable surface that touches the exterior surface of the photosensitive element during thermal processing. The photosensitive element is mounted to the exterior surface of the drum and the leading of the element is engaged in a clamp on the drum. The thermal processing device includes at least one means to heat the photosensitive element at a heating station to achieve the desired temperature for melting, softening or liquefying the composition layer on the element. A hot roll brings the development medium into contact with the photosensitive element and heats the exterior surface of the photosensitive element. As the photosensitive element rotates on the drum, the development medium supported by the hot roll will contact with the exterior surface of the photosensitive element. The photosensitive element composition layer is heated to between 40 and 230°C (104 and 392°F) while in contact with the development medium. The development medium contacts the exterior surface of the composition layer of the heated photosensitive element, and absorbs the liquefied portions of the polymer from the unirradiated portions of the composition layer, forming a relief pattern or surface suitable for use as a flexographic printing form. By maintaining more or less intimate contact of the development medium with the composition layer that is molten in the uncured regions, a transfer of the uncured photosensitive material from the composition layer to the development material takes place. While still in the heated condition, the development material is separated from the cured photosensitive element to reveal the relief structure. As the trailing edge of the element passes the hot roll/drum contact point, i.e., nip, the heater or heaters may cool down or turn off. The drum may return the leading edge of the element to the home position to begin another cycle of heating and contacting. The at least one steady rollers contact the exterior surface of the photosensitive element as the drum rotates to the home position, and typically become contaminated with residue or uncured material from the photosensitive element. A cycle of the steps of heating the element to liquefy the composition layer and contacting the molten (portions) layer with the development material can be repeated as many times as necessary to adequately remove the uncured material and create sufficient relief depth. However, it is desirable to minimize the number of cycles for suitable system performance, and typically the photopolymerizable element is thermally treated for 5 to 15 cycles.

To clean the contactable surfaces of the automatic thermal development device, the cleaning element is passed through the device so that the adhesive layer of the cleaning element contacts the contactable surface to transfer the at least one contaminant from the contactable surface onto the adhesive layer and thereby capture the contaminant from the device. The cleaning element is passed through the device in the same or substantially the same way that the photosensitive element is transported through the thermal development process device. In one embodiment, the cleaning element has the same or substantially the same or similar flexibility as the photosensitive element, so that the cleaning element can pass through the device in substantially the same manner as a photosensitive element. In another embodiment the cleaning element is somewhat less flexible than a photosensitive element, e.g., a stack of cleaning elements, in which case care should be taken to size the cleaning element or to adjust the device to accommodate the transport of the cleaning element so as not to harm the functional parts of the device.

There is no particular limitation for the temperature at which the cleaning element is passed through the device, provided that the cleaning element is sufficiently stable to not degrade and to be able to function at the cleaning temperature. As such cleaning of the contactable surface with the cleaning element can occur at any temperature from ambient room conditions to operating temperature of the thermal development device, provided that that. In one embodiment, the cleaning of the contactable surface can be conducted while the automatic device is preheating, while preparing for thermal development of one or more photosensitive elements. In this embodiment, the support member, e.g., drum, which holds the photosensitive element is heated to a temperature of between 23.9 to 29.4°C (75-85°F) while the cleaning element is passing through the device. In another embodiment, one or more of the heatable elements at the heating station, i.e., hot roll, infrared heater, and drum heater, may be heated to about 40°C (104°F) while the cleaning element is passing through the device. In another embodiment, the device may be heated to thermal development temperature during one or more of the passes of the cleaning element through the device. In general the hot roll, particularly if hot or being heated, nor the development medium carried by the hot roll, do not contact the cleaning element.

In the embodiment described above in which the thermal development device includes a drum to support the photosensitive element and at least one steady roller, the cleaning element is positioned on the drum and a leading edge of the cleaning element is held by a clamp to the drum. In one embodiment, no heating occurs at the heating station during one or more of the cleaning cycles. As the cleaning element rotates on the drum the adhesive layer contacts the contactable surfaces of the at least one steady roller and transfers the residue or uncured material or foreign bodies contaminating the contactable surface. The cleaning element passing the at least one contactable surface one time is considered a cycle. The cleaning element passes the contactable surface for one or more cycles sufficient to reduce the level of residue or material or foreign bodies contaminating the contactable surface or to eliminate or substantially eliminate contaminants from the contactable surface. In one embodiment, the cleaning element is passed through the cleaning cycle 1 to 15 times. In another embodiment, the cleaning element is passed through the cleaning cycle 5 to 20 times. The development medium does not contact the cleaning element during the cleaning cycles. When the cleaning is complete, the cleaning element is removed from the support member.

In an embodiment in which the cleaning element is a stack of cleaning elements, the stack of cleaning elements can pass through the device wherein the adhesive layer of an uppermost cleaning element of the stack touches the contactable surface of the device. As the uppermost cleaning element becomes dirty or covered with contaminants, the uppermost cleaning element is removed by peeling from the stack of underlying cleaning elements. The (remaining) stack of cleaning elements may continue to be passed through the device to transfer contaminant from the at least one contactable surface, and then removing the uppermost cleaning element as it becomes dirty until a few cleaning elements remain or the stack is consumed.

The process of cleaning the contactable surface is particularly effective at maintaining the cleanliness of the contactable surface if done on a routine basis, such as daily. The cleaning method removes or significantly slows down the accumulation of contaminants on the contactable surface.

Thermal treating, which may also be called thermal development, includes heating of an exterior surface of the composition layer of the photosensitive element to a temperature sufficient to cause a portion of the layer to liquefy. The at least one photosensitive layer (and additional layer/s if present) can be heated by conduction, convection, radiation or other heating methods to a temperature sufficient to effect melting of the uncured portions but not so high as to effect distortion of the cured portions of the layer. One or more additional layers disposed above the composition layer may soften or melt or flow and be absorbed as well by an absorbent material. The photosensitive element is heated to a surface temperature above about 40°C, preferably from about 40°C to about 230°C (104-446 °F) in order to effect melting or flowing of the uncured portions of the composition layer. The thermal treating steps of heating the photosensitive element and contacting an outermost surface of the element with development medium can be done at the same time, or in sequence provided that the uncured portions of the photopolymerizable layer are still soft or in a melt state when contacted with the development medium.

The development medium includes an absorbent material that is selected to have a melt temperature exceeding the melt or softening or liquefying temperature of the unirradiated or uncured portions of the radiation curable composition and having good tear resistance at the same operating temperatures. Preferably, the absorbent material withstands temperatures required to process the photosensitive element during heating. The absorbent material is selected from non-woven materials, paper stocks, fibrous woven materials, open-celled foams, porous materials that contain a fraction or a substantial fraction of their included volume as void volume. The absorbent material should also possess a high absorbency for the molten elastomeric composition as measured by the milligrams of elastomeric composition that can be absorbed per square centimeter of the development medium. It is also desirable that fibers are bonded in absorbent material so that the fibers are not deposited into the printing form during development. Preferred for the absorbent material are non-woven webs of nylon or polyester. The absorbent material has a thickness between 2 to 25 mils (0.005 to 0.064 cm), preferably 2 to 20 mils (0.005 to 0.051 cm).

The use of the term absorption in defining the relative physical property between the absorbent material of the development medium and the melted uncured elastomeric composition is not intended to be limited to particular absorptive phenomena. There need not be penetration of the melted composition into the body of fibers, filaments or particles used for the absorbent material. The absorption into the bulk of the absorbent material may be only by surface wetting of the interior bulk. The driving force for the movement of the melted elastomeric composition into the absorptive areas of the development medium may be one or more of surface tension, electrical forces, polarity attraction or other physical forces known to assist in promoting philicity (that is, an affinity for), adsorption, or absorption of materials. The driving force may also include pressure driven flow into a porous media.

The support member for the photosensitive element, for example a drum, may be equipped with a heater, which is provided to keep the photosensitive element at a stable starting temperature independent of the surrounding environment. Any means of heating the support member is acceptable, as long as the power capacity of the heater is sufficient to maintain a fairly constant selected skin temperature on an outer surface of the drum of about 50-150°F (10-65.6 °C), preferably 65 to 95 °F (18.3-35 °C). The means for heating the drum is capable of heating the drum to a temperature capable of heating the exterior surface of the composition layer. The heater may be an electrical heating blanket, such as a wire wound blanket. If the normal operating environment is carefully controlled to be at a constant temperature, the heater can be turned off or omitted from the apparatus. As is disclosed in US Patent 6,797,454, it is also possible that the drum be cooled by cooling means, such as, a blower directing a stream of air at the surface of the photosensitive element and the drum and/or by the circulating of cooling fluid beneath the surface of the drum to cool the support side of the element.

Optionally, located adjacent the support member is a first heating means comprising is a radiant heater directed at the photosensitive element. The heater can provide focused or diffused radiant heat to the exterior surface of the photosensitive element. The heater elevates the temperature of the exterior surface of the composition layer. In one embodiment, the heater elevates the temperature of the surface of the composition layer to a temperature sufficient to melt the unirradiated portion of the composition layer, causing a portion of the layer to liquefy. The heater is a type of heater that does not appreciably heat the substrate supporting the composition layer. The heater can include one or a plurality of tubular infrared heating bulbs. Adjacent the bulbs opposite drum can be a reflector that acts to direct the infrared radiation toward the exterior surface of the photosensitive element.

The device delivers the development medium supported by the hot roller to the exterior surface of the photosensitive element. The hot roller is positioned adjacent the support member that carries the photosensitive element, and adjacent the radiant heater. The hot roller is a second means for heating that maintains or further elevates the temperature of the exterior surface of the composition layer. The hot roller applies heat to the exterior surface of the photosensitive element.

The radiant heater acting as a first heating means, the hot roller acting as a second heating means, and the support member heater acting as a third heating means, independently or in any combination, are capable of heating the exterior surface of the photosensitive element to a temperature sufficient to cause a portion, i.e., an unirradiated portion, of the composition layer to liquefy. The first heating means, the second heating means, and the third heating means independently or in any combination constitute a heating station. A preferred heating station includes the first heating means and the second heating means. Temperature sensors may be mounted throughout the processor to monitor the temperature for the purpose of controlling the heating elements in the support member, the hot roller, and the radiant heater.

The photosensitive element comprises at least one composition layer capable of being partially liquefied upon thermal development. That is, during thermal development the uncured composition must soften or melt or flow at a reasonable processing or developing temperature but not be subject to cold flow, i.e., dimensional change, during normal storage. Preferably, the photosensitive element is an elastomeric printing element suitable for use as a flexographic printing form. The composition layer is preferably a photosensitive layer, and most preferably a photopolymerizable layer of an elastomeric composition wherein the photosensitive layer can be selectively cured by actinic radiation. As used herein, the term "photopolymerizable" is intended to encompass systems that are photopolymerizable, photocrosslinkable, or both. Throughout this specification actinic radiation will include ultraviolet radiation and/or visible light.

Photosensitive elements suitable for use as a flexographic printing forms are well known in the art. Examples of suitable photosensitive elements are disclosed in U.S. Patent 4,323,636 (Chen); U.S. Patent 4,753,865 (Fryd et al.); U.S. Patent 4,726,877(Fryd et al.); U.S. Patent 4,894,315 (Feinberg et al.); U.S. Patent 4,427,759 U.S. 4,460,675; U.S. Patent 5,262,275; U.S. Patent 5,719,009; and U.S. Patent 6,238,837. Particularly preferred are photosensitive elements that include a photopolymerizable layer having specific rheological properties as disclosed by Mengel et al. in PCT publication WO 01/88615 A1.

A preferred example of an elastomeric composition comprises at least one elastomeric binder, at least one monomer, and at least one photoinitiator or a photoinitiator system. Preferably, the binder is a thermoplastic elastomeric block copolymer such as an A-B-A type block copolymer, where A represents a non-elastomeric block, preferably a vinyl polymer and most preferably polystyrene, and B represents an elastomeric block, preferably polybutadiene or polyisoprene. Polyurethane elastomers may also be used as disclosed in U.S. Pat. No. 5,015,556.

The photopolymerizable composition contains at least one monomer compatible with the binder to the extent that a clear, non-cloudy photosensitive layer is produced. The at least one monomer can be a single monomer or mixture of monomers. Monomers that can be used in the photopolymerizable composition are well known in the art and include, but are not limited to, addition-polymerization ethylenically unsaturated compounds with at least one terminal ethylenic group. Examples of suitable monomers include, but are not limited to, the acrylate and methacrylate mono- and poly-esters of alcohols and polyols. A mixture of monofunctional and multifunctional acrylates or methacrylates may be used. Other examples of suitable monomers include acrylate and methacrylate derivatives of isocyanates, esters, epoxides and the like. Monomers can be appropriately selected by one skilled in the art to provide elastomeric property to the photopolymerizable composition. Examples of elastomeric monomers include, but are not limited to, acrylated liquid polyisoprenes, acrylated liquid butadienes, liquid polyisoprenes with high vinyl content, and liquid polybutadienes with high vinyl content, (that is, content of 1-2 vinyl groups is greater than 20% by weight). Further examples of monomers can be found in Chen U.S. Patent No. 4,323,636; Fryd et al., U.S. Patent No. 4,753,865; Fryd et al., U.S. Patent No. 4,726,877 and Feinberg et al., U.S. Patent No. 4,894,315.

The photoinitiator can be any single compound or combination of compounds which is sensitive to actinic radiation, generating free radicals which initiate the polymerization of the monomer or monomers without excessive termination. Any of the known classes of photoinitiators, particularly free radical photoinitiators may be used. Alternatively, the photoinitiator may be a mixture of compounds, one of which provides the free radicals when caused to do so by a sensitizer activated by radiation. Preferably, the initiator is sensitive to visible or ultraviolet radiation.

The photopolymerizable layer can contain other additives depending on the final properties desired. Additional additives to the photopolymerizable layer include sensitizers, plasticizers, rheology modifiers, thermal polymerization inhibitors, colorants, processing aids, antioxidants, antiozonants, UV absorber and fillers. Processing aids may include low molecular weight polymers compatible with the elastomeric block copolymer. Antiozonants include hydrocarbon waxes, norbornenes, and vegetable oils. Suitable antioxidants include alkylated phenols, alkylated bisphenols, polymerized trimethyldihydroquinone, and dilauryl thiopropinoate.

Plasticizers are used to adjust the film forming properties of the elastomer. Examples of suitable plasticizers include aliphatic hydrocarbon oils, e.g., naphthenic and paraffinic oils; liquid polydienes, e.g., liquid polybutadiene; and liquid polyisoprene. Generally, plasticizers are liquids having molecular weights of less than about 5000, but can have molecular weights up to about 30,000.

Flexographic printing plates formed from photopolymerizable compositions which are soluble, swellable, or dispersible in aqueous, semi-aqueous, or organic solvent developers (so called wet development) may also be suitable for use in the present invention to the extent that the photopolymerizable composition is also capable of liquefying upon thermal development to form a relief surface. Examples of suitable compositions for solvent development have been disclosed, for example, in Chen et al., U.S. Patent 4,323,637, Gruetzmacher et al., U.S. Patent 4,427,749 and Feinberg et al., U.S. Patent 4,894,315.

The thickness of the photopolymerizable layer can vary over a wide range depending upon the type of printing plate desired, for example, from about 0.010 inches to about 0.250 inches or greater (about 0.025 cm to about 0.64 cm or greater). For so-called "thin plates" typically the photopolymerization layer can range from about 0.010 inches to about 0.067 inches (about 0.025 cm to about 0.17 cm) in thickness.

The support can be any material that is conventionally used with photosensitive elements used to prepare flexographic printing plates. Preferably the support is transparent to actinic radiation to accommodate "backflash" exposure through the support. Examples of suitable support materials include polymeric films such those formed by addition polymers and linear condensation polymers, transparent foams and fabrics. Under certain end-use conditions metals, such as aluminum, may also be used as a support, even though a metal support is not transparent to radiation. A preferred support is a polyester film; particularly preferred is polyethylene terephthalate. The support may be in sheet form or in cylindrical form, such as a sleeve. The type of sleeve or cylindrical support is not limited by the present invention. The support typically has a thickness from 0.002 to 0.050 inch (0.0051 to 0.127 cm). The sleeve can have a wall thickness from less than 10 mils (0.025 cm) to 80 mils( 0.203 cm) or more, but typically has a wall thickness of 10 to 40 mils (0.025 to 0.10 cm).

Additional layers may be present on top of the photopolymerizable layer, that is, on a side of the photopolymerizable layer opposite the support. These layers may comprise at least one thermally removable layer on the photopolymerizable layer, such as disclosed by Fan et al. in U.S. Patent 6,773,859 B2. Depending on desired use, the additional layers may be opaque or transparent to actinic radiation. They may have one or more functions for the photosensitive element including, but not limited to, a release layer, an actinic radiation opaque layer, an infrared sensitive layer, a barrier layer, an elastomeric cap layer, an adhesion modifying layer, a layer which alters the surface characteristics of the photosensitive element, and combinations thereof.

Before thermal treatment according to the present invention, the photosensitive element is exposed to actinic radiation. Upon imagewise exposure, the radiation-exposed areas of the photopolymerizable layer are converted to the insoluble state with no significant polymerization or crosslinking taking place in the unexposed areas of the layer. Any conventional source of actinic radiation can be used for this exposure. The radiation sources generally emit long-wave UV radiation between 310-400 nm. The exposure time may vary from a few seconds to minutes, depending upon the intensity and spectral energy distribution of the radiation, its distance from the photosensitive element, and the nature and amount of the photopolymerizable material.

Imagewise exposure can be carried out by exposing the photosensitive element through an image-bearing photomask that can be a separate film, i.e., an image-bearing transparency or phototool, or be integrated with the photosensitive element as an in-situ mask formed by computer-to-plate digital imaging.

Following imagewise exposure to actinic radiation through the mask and removal of the photomask if it is a separate film, the photosensitive printing element is thermally treated to remove unpolymerized areas in the photopolymerizable layer and thereby form a relief image. The thermal treating step removes at least the photopolymerizable layer in the areas that were not exposed to actinic radiation, i.e., the unexposed areas or uncured areas, of the photopolymerizable layer. Except for the elastomeric capping layer, typically the additional layers that may be present on the photopolymerizable layer are removed or substantially removed from the polymerised areas of the photopolymerizable layer. For photosensitive elements including a separate IR-sensitive layer for digital formation of the mask, the treating step that forms the relief image in the photopolymerizable layer may also remove the mask image (which had been exposed to actinic radiation).

## Claims

1. A method for cleaning contaminants from an automatic process device for forming a relief surface from a photosensitive element having an exterior surface and containing a composition layer capable of being partially liquefied, comprising:
a) providing the device with a contactable surface capable of contacting the exterior surface of the element where a portion of the composition can remain, the contactable surface having at least one contaminant thereon;
b) providing a cleaning element comprising a support having on one side an adhesive layer adapted to contact the contactable surface;
c) passing the cleaning element through the device so that the adhesive layer contacts the contactable surface and thereby transfers the at least one contaminant from the contactable surface onto the adhesive layer.

2. The method of Claim 1 wherein the device comprises more than one contactable surface.

3. The method of Claim 1 wherein the device further comprises one or more rollers each having a contactable surface.

4. The method of Claim 1 wherein the device comprises at least one member having a contactable surface, the at least one member selected from the group consisting of roller, roll, guide member, and guide plate.

5. The method of Claim 1 further comprising heating the device to 40°C.

6. The method of Claim 1 further comprising heating the device between 40 and 230°C.

7. The method of Claim 1 wherein the cleaning element is flexible.

8. The method of Claim 1 wherein the cleaning element is a sheet.

9. The method of Claim 1 wherein the cleaning element is a cylinder.

10. The method of Claim 1 wherein the cleaning element comprises a stack of two or more cleaning elements one on top of the other, wherein each cleaning element of the stack has an adhesive layer on a support.

11. The method of Claim 10 wherein the stack further comprises a carrier.

12. The method of Claim 10 further comprising removing one cleaning element from the stack of cleaning elements to reveal an adhesive layer from an adjacent cleaning element.

13. The method of Claim 1 wherein the at least one contaminant is a portion of the composition remaining on the contactable surface.

14. The method of Claim 1 wherein the at least one contaminant is a foreign body selected from the group consisting of hair, fur, fiber, and dust.

15. The method of Claim 1 further comprising pressing the contactable surface into contact with the cleaning element.

16. The method of Claim 1 wherein the adhesive is a pressure-sensitive adhesive.

17. The method of Claim 1 wherein the adhesive has a tackiness of at least 0.1 Newton.
